# EUROPEAN PATENT APPLICATION

(11) **EP 4 391 039 A1**
(43) Date of publication of application: **26.06.2024**
(21) Application number: 22215085.6
(22) Date of filing: 20.12.2022
(51) Int. Cl.: H01L 21/822, H01L 21/8238, H01L 27/06, H01L 27/092, H01L 29/06, H01L 29/775

(54) **A METHOD FOR FORMING A SEMICONDUCTOR DEVICE**

(71) Applicant: Imec VZW, 3001 Leuven (BE); Katholieke Universiteit Leuven KU Leuven Research & Development, 3000 Leuven (BE)
(72) Inventor: CHAN, Boon Teik, 3012 Wilsele (BE); LIU, Hsiao-Hsuan, 3001 Leuven (BE); SALAHUDDIN, Shairfe Muhammad, 3000 Leuven (BE)
(74) Representative: AWA Sweden AB

(57) **Abstract**

The disclosure relates to a method for forming a semiconductor device, comprising:
forming a first bottom and top channel structures, and second bottom and top channel structures, and a sacrificial gate extending across the channel structures;
forming an opening in the sacrificial gate, over the first top channel structure and forming a cut through the first top channel structure;
forming a dielectric plug in the cut and the opening;
removing the sacrificial gate and subsequently forming an RMG structure comprising a first gate stack on the first bottom channel structure and a second gate stack on the second bottom and top channel structures,;
forming pairs of S/D structures on the first bottom channel structure, the second bottom channel structure, and the second top channel structure;
forming S/D contacts on the S/D structures;
forming a trench for a cross-couple contact by etching a dielectric gate capping layer and a dielectric contact capping layer, the trench extending from the second gate stack, over the dielectric plug, to a first S/D contact on a first S/D structure of the pair of S/D structures on the first bottom channel structure; and
forming the cross-couple contact in the trench, the contact interconnecting the second gate stack and the first S/D contact.

## Description

### Technical field

The present disclosure relates to a method for forming a semiconductor device.

### Background

In the strive to provide ever more area-efficient circuit designs, vertically stacked transistor devices are being developed. One notable example is the Complementary field-effect transistor (CFET) device in which two horizontal channel transistors of complementary conductivity types are stacked on top of each other (e.g. a pFET bottom device and an nFET top device, or vice versa). The CFET device allows a reduced footprint compared to a traditional side-by-side arrangement of a pFET and nFET. The two device levels provided by the CFET (e.g. a "2-level middle-of line / MOL") further enables a reduced routing layer usage in the back-end-of line (BEOL). The CFET is hence an enabler for area-efficient Complementary Metal-Oxide Semiconductor (CMOS) circuitry.

Using what may be referred to as a "monolithic" process, a CFET device may be formed by patterning a deposited stack of channel layers top-down to form stacks of channel layers (e.g. into the form of nanosheets) for both the bottom device and the top device. After processing source and drain structures (e.g. by epitaxy) and forming source and drain contacts for the bottom and top devices, the channel layers of the bottom and top devices may be provided with a gate stack. The gate stack may also be formed in a "monolithic" process wherein the gate patterning for the top and bottom device is performed simultaneously. The CFET device may in particular be provided with a gate which is shared by, i.e. common to, the bottom and top devices.

Some integrated circuits require a combination of CMOS and non-CMOS devices. Examples include, but are not limited to, SRAM bit cells, latches and flip-flops which include, in addition to CMOS devices (e.g. CMOS inverter pairs), a pass gate or pass transistor. In a CFET device with a common gate electrode, either the nFET or pFET will be on regardless of a high or low logic level gate voltage. A pass gate function may hence not be provided by a typical CFET device. Moreover, the aforementioned circuit examples may require a cross-coupling between the gate of the CFET device and a source/drain of the pass gate.

### Summary

In light of the above, it would be desirable to provide a method facilitating fabrication of a non-stacked transistor structure (e.g. suitable for a pass gate) and a stacked transistor structure (e.g. suitable for a CFET) having a gate coupled to the source/drain. Further and alternative objectives may be understood from the following.

According to an aspect there is provided a method for forming a semiconductor device, comprising:
forming, over a substrate, a first bottom channel structure and a first top channel structure stacked on top of the first bottom channel structure, and a second bottom channel structure and a second top channel structure stacked on top of the second bottom channel structure, and a sacrificial gate extending across the first and second bottom and top channel structures;
forming an opening in the sacrificial gate, over the first top channel structure and forming a cut through the first top channel structure by etching the first top channel structure from the opening in the sacrificial gate, wherein the etching extends completely through the first top channel structure and is stopped over the first bottom channel structure;
forming a dielectric plug in the cut and the opening;
removing the sacrificial gate and subsequently forming a replacement metal gate (RMG) structure comprising a first gate stack on the first bottom channel structure and a second gate stack on the second bottom and top channel structures, and forming a dielectric gate capping layer over the RMG structure and the dielectric plug;
forming a first pair of source/drain (S/D) structures on the first bottom channel structure, a second pair of S/D structures on the second bottom channel structure, and a third pair of S/D structures on the second top channel structure;
forming S/D contacts on the S/D structures;
forming a dielectric contact capping layer over the S/D contacts;
forming a trench for a cross-couple contact by etching the dielectric gate capping layer and the dielectric contact capping layer, the trench extending from the second gate stack, over the dielectric plug, to a first S/D contact on a first S/D structure of the first pair of S/D structures; and
forming the cross-couple contact in the trench, the contact interconnecting the second gate stack and the first S/D contact.

The present method enables fabrication of a non-stacked transistor structure (e.g. suitable for a pass gate) and a stacked transistor structure (e.g. suitable for a CFET), wherein the gate stack of the stacked transistor structure is interconnected (i.e. cross-coupled) with the first S/D contact of the non-stacked transistor structure.

The method is based on the insight that a non-stacked transistor structure may be formed from an initial stacked transistor structure, by supplementing processing steps for forming a stacked transistor device structure with steps for selectively removing the top channel structure from the initial stacked transistor structure. The removal is enabled by etching a cut through the first top channel structure. More specifically, the cut may be etched through each of one or more top channel layers of the first top channel structure. By cutting the top channel structure/the top channel layer(s), formation of an active device at the first top channel structure may hence be prevented.

By forming the cut via the opening in the sacrificial gate, the cut may be etched in a self-aligned manner with respect to an active region or channel region of the first bottom and top channel structures. In other words, the reliance on the sacrificial gate structure imposes a constraint on the position of the cut, thus facilitating area selective formation of a non-stacked transistor structure.

Since the etching of the cut is stopped over the first bottom channel structure, the first bottom channel structure (e.g. comprising one or more bottom channel layers) is preserved (i.e. not cut or etched) such that a non-stacked transistor device may be formed at the first bottom channel structure.

As the dielectric plug is formed in the cut through the first top channel structure and in the opening in the sacrificial gate, the dielectric plug may be formed in a self-aligned manner with respect to / on top of the first bottom channel structure. The dielectric plug furthermore blocks forming of a gate stack in the cut, and may hence provide a vertical isolation margin between the subsequently formed cross-couple contact and the first gate stack on the first bottom channel structure.

Meanwhile, since the sacrificial gate is opened selectively over the first top channel structure, a stacked transistor structure may be formed at the second bottom and top channel structures.

Each one of the first and second bottom and top channel structures may comprise a number of (i.e. one or more) (bottom/top) channel layer. In case a channel structure comprises of two or more channel layers, the two or more channel layers may be vertically stacked such that the channel structure comprises two or more vertically channel layers. Each (bottom/top) channel layer may be a (bottom/top) channel nanosheet. The term "nanosheet" as used herein refers to a layer of nanoscale dimensions.

Relative spatial terms such as "vertical", "upper", "lower", "top", "bottom", "above", "under", "below", are herein to be understood as denoting locations or orientations within a frame of reference of the substrate. In particular, the terms may be understood as locations or orientations along a normal direction to the substrate (i.e. a main plane of extension of the substrate). Correspondingly, terms such as "lateral" and "horizontal" are to be understood as locations or orientations parallel to the substrate (i.e. parallel to the main plane of extension of the substrate).

The term "pair of S/D structures" is herein to be understood to refer to a respective first and a second S/D structure formed at either/opposite side(s) of the sacrificial gate structure. Accordingly, the first pair of S/D structures comprises a first S/D structure and a second S/D structure formed on opposite ends of the first bottom channel structure. The second pair of S/D structures comprises a first S/D structure and a second S/D structure formed on opposite ends of the second bottom channel structure. The third pair of S/D structures comprises a first S/D structure and a second S/D structure formed on opposite ends of the second top channel structure. Each pair of source/drain structures may be formed by epitaxy to grow a pair of epitaxial bottom S/D bodies (i.e. a first and a second S/D body on opposite ends of the respective channel structure).

For clarity, the opening, the cut, the dielectric plug, the dielectric gate capping layer, the dielectric contact capping layer, the trench and the cross-couple contact mentioned above may be prefixed by the label "first", to distinguishing from corresponding elements prefixed "second" below.

The first and second pairs of source/drain structures may be formed subsequent to forming the sacrificial gate and prior to forming the opening and the cut.

The third pair of S/D structures may advantageously be formed subsequent to forming the opening and the cut, in accordance with some embodiments as further set out below. However, it is also possible to form the third pair of S/D structures subsequent to forming the sacrificial gate and prior to forming the opening and the cut.

In some embodiments, the second gate stack may comprise a lower gate sub-stack surrounding the second bottom channel structure and an upper gate sub-stack surrounding the second top channel structure, wherein the first gate stack and the lower gate sub-stack may be an N-type gate and the upper gate sub-stack may be a P-type gate stack, or vice versa. This allows forming a non-stacked N-type transistor structure adjacent a CFET transistor structure comprising a N-type bottom device and P-type top device, or a non-stacked P-type transistor structure adjacent a CFET transistor structure comprising a P-type bottom device and N-type top device.

In some embodiments, the trench may expose a top surface of the second gate stack and a top surface of the first S/D contact. The cross-couple contact may hence be formed in contact with respective top surfaces of the second gate stack and the first S/D contact. A required depth of the trench etch may hence be limited.

In some embodiments, the respective top surface of the first source/drain contact and the second gate stack may be located at a level above the top surface of the dielectric plug. This facilitates ensuring that the trench does not expose the first gate stack on the first bottom channel structure underneath the dielectric plug.

In some embodiments, forming the trench may further comprise etching a portion of a gate spacer present between the replacement metal gate structure and the first S/D contact. The gate spacer may hence be opened such that the trench may bridge the gate spacer. The method may comprise forming the gate spacer after forming the sacrificial gate and prior to forming the opening in the sacrificial gate. The gate spacer may be formed on opposite sidewalls of the sacrificial gate. The etching of the portion of the gate spacer may be conducted at the side of the sacrificial gate structure facing the first S/D contact.

In some embodiments, the first and the second gate stacks may be separated by a vertically oriented dielectric wall. This enables independent control of the gate voltages applied to the first and second gate stacks.

The dielectric wall may be formed between the first bottom and top channel structures and the second bottom and top channel structures prior to forming the sacrificial gate structure, and wherein the method may comprise forming a cut in the RMG structure, the cut landing on a top of the dielectric wall and the dielectric plug, to disconnect the first gate stack from the second gate stack. Electrically disconnected first and second gate stacks may hence be formed employing a metal gate cut, wherein the presence of the dielectric wall reduces a required depth of the metal gate cut (i.e. the metal etch back) to disconnect the first and second gate stacks.

In some embodiments, a dielectric separation layer may be located between the first bottom and top channel structures, and between the second bottom and top channel structures, and wherein the etching for forming the cut through the first top channel structure may be stopped over or on the dielectric separation layer. The (first) dielectric separation layer between the first bottom and top channel structures may increase a process margin for the cut formation, such that unintentional etching of the first bottom channel structure during the cut formation may be avoided. In particular, the dielectric separation layer may be used as an etch stop layer for the etching of the cut. The (second) dielectric separation layer between the second bottom and top channel structures may facilitate forming the second gate stack as a CMOS / dual-work function metal (WFM) gate stack.

In some embodiments, the opening may be formed to selectively expose a top surface portion of the first top channel structure, wherein/such that portions of the sacrificial gate remain along sidewalls of the first bottom and top channel structures after forming the opening. The remaining portions of the sacrificial gate may thus be used as an etch mask for the first bottom channel structure during the forming of the cut.

In some embodiments, the method may further comprise applying, via the cut, an isotropic etching process for removing portions of the first top channel structure remaining along the cut. For various reasons (some of which are discussed in greater detail below) the etching of the cut through the first top channel structure may not entirely remove the first top channel structure (e.g. the one or more channel layers thereof). Accordingly, the isotropic etching process enables removing such portions of channel material/the channel layer(s) remaining subsequent to forming the cut through the first top channel structure.

For example, a gate spacer may be formed on sidewalls of the sacrificial gate, wherein the isotropic etching process may remove end portions of the first top channel structure (e.g. the one or more channel layers thereof) remaining below the gate spacer after forming the cut.

The first top channel structure may comprise a number of channel layers and a number of sacrificial layers alternating the channel layers, wherein end portions of the sacrificial layers may be recessed with respect to the end portions of the channel layers and covered by insulating inner spacer portions, wherein the isotropic etching process may remove the end portions of each of the channel layer(s) of the first top channel structure remaining below the inner spacer portions after forming the cut. The sacrificial layers may be removed selectively to the channel layers after removing the sacrificial gate and prior to forming the RMG structure.

It is to be understood that also the second top channel structure may comprise a corresponding alternating arrangement of channel layers and sacrificial layers, wherein end portions of the sacrificial layers may be recessed with respect to the end portions of the channel layers and covered by insulating inner spacer portions.

In some embodiments the third pair of S/D structures on the second top channel structure are formed in an epitaxy process subsequent to applying the isotropic etching process. By removing remaining portions of the first top channel structure (e.g. the one or more channel layers thereof) along the cut, deposition/epitaxy of S/D material on remaining channel material of the first top channel structure layer (e.g. channel end portions preserved underneath the gate spacer and/or inner spacers) may be avoided, such that the epitaxy process may form a pair of S/D structures (i.e. the third pair) selectively on the second top channel structure. This may increase the space available for S/D contacts over the first bottom channel structure.

In some embodiments, the first bottom and top channel structures may be formed along a first fin structure and the second bottom and top channel structures may be formed along a second fin structure parallel to the first fin structure, wherein the sacrificial gate may form a first sacrificial gate extending transverse to the first and second fin structures, across the first and second bottom and top channel structures, and wherein the RMG structure may forms a first RMG structure, and the method may further comprise:
forming, along the first fin structure, a third bottom channel structure and a third top channel structure stacked on top of the third bottom channel structure, and a second sacrificial gate parallel to the first sacrificial gate and extending across the third bottom and top channel structures;
removing the second sacrificial gate and subsequently forming a second RMG structure comprising a third gate stack on the third bottom and top channel structures; and
forming a fourth pair of S/D structures on the third bottom channel structure and a fifth pair of S/D structures on the third top channel structure, wherein a first S/D structure of the fourth pair of S/D structures merges with the first S/D structure of the first pair of S/D structures;
wherein forming the S/D contacts comprises forming said first S/D contact on the merged first S/D structures and a first S/D structure of the fifth pair of S/D structures.

A non-stacked transistor structure and a stacked transistor structure (e.g. suitable for a second CFET) may hence be formed after one another along a same first fin structure, wherein the first S/D contact may define a common contact for the merged first S/D structures and the first S/D structure of the fifth pair of S/D structures. As may be understood these "first S/D structures" are each formed along the first fin structure at a location between the first and second sacrificial gates. This results in a device structure suitable in circuits combining CMOS and non-CMOS devices.

Embodiments comprising forming the third bottom and top channel structures may advantageously comprise forming the third and fifth pairs of source/drain structures in an epitaxy process subsequent to applying the aforementioned isotropic etching process. Merging of S/D structures at the top channel structure level may hence be avoided. This increases the space available for the first S/D contact, e.g. facilitating the first S/D contact to wrap-around the first S/D structure of the fifth pair of S/D structures (formed on the third top channel structure).

In some embodiments comprising forming the third bottom and top channel structures, the method may further comprise:
forming, along the second fin structure, a fourth bottom channel structure and a fourth top channel structure stacked on top of the fourth bottom channel structure, wherein the second sacrificial gate is formed to further extend across the fourth bottom and top channel structures;
forming an opening in the second sacrificial gate, over the fourth top channel structure and forming a cut through the fourth top channel structure by etching the fourth top channel structure from the opening in the second sacrificial gate, wherein the etching extends completely through the fourth top channel structure and is stopped over the fourth bottom channel structure;
forming a (second) dielectric plug in the cut through the fourth top channel structure and the opening in the second sacrificial gate;
removing the second sacrificial gate and subsequently forming the second RMG structure comprising a third gate stack on the third bottom and top channel structures, and a fourth gate stack on the fourth bottom channel structure, and forming a (second) dielectric gate capping layer over the second RMG structure and the (second) dielectric plug;
forming a sixth pair of S/D structures on the fourth bottom channel structure,
wherein a first S/D structure of the sixth pair of S/D structures merges with a first S/D structure of the second pair of S/D structures (formed on the second bottom channel structure), and
wherein forming the S/D contacts comprises forming a second S/D contact on the merged first S/D structures (of the sixth and second pairs of S/D structures) and a first S/D structure of the second pair of S/D structures (on the second top channel structure);
forming a (second) trench for a (second) cross-couple contact by etching the (second) dielectric gate capping layer and the (second) dielectric contact capping layer, the (second) trench extending from the third gate stack, over the (second) dielectric plug, to the second S/D contact; and
forming the (second) cross-couple contact in the (second) trench, the (second) contact interconnecting the third gate stack and the second S/D contact.

Thereby, two pairs of stacked transistor structures (e.g. suitable for a CFET) with respective gates cross-coupled to the S/D contact of a respective non-stacked transistor structure (e.g. suitable for a pass gate) may be formed along two parallel fin structures and two parallel sacrificial gates. The details and discussion above in relation to the first and second bottom and top channel structures apply correspondingly to the fourth and third bottom and top channel structures, respectively.

In some embodiments, the third gate stack may comprise a lower gate sub-stack surrounding the third bottom channel structure and an upper gate sub-stack surrounding the third top channel structure, wherein the fourth gate stack and the lower gate sub-stack of the third gate stack may be an N-type gate and the upper gate sub-stack may be a P-type gate stack, or vice versa. This allows forming a non-stacked N-type transistor structure adjacent a CFET transistor structure comprising a N-type bottom device and P-type top device, or a non-stacked P-type transistor structure adjacent a CFET transistor structure comprising a P-type bottom device and N-type top device.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.

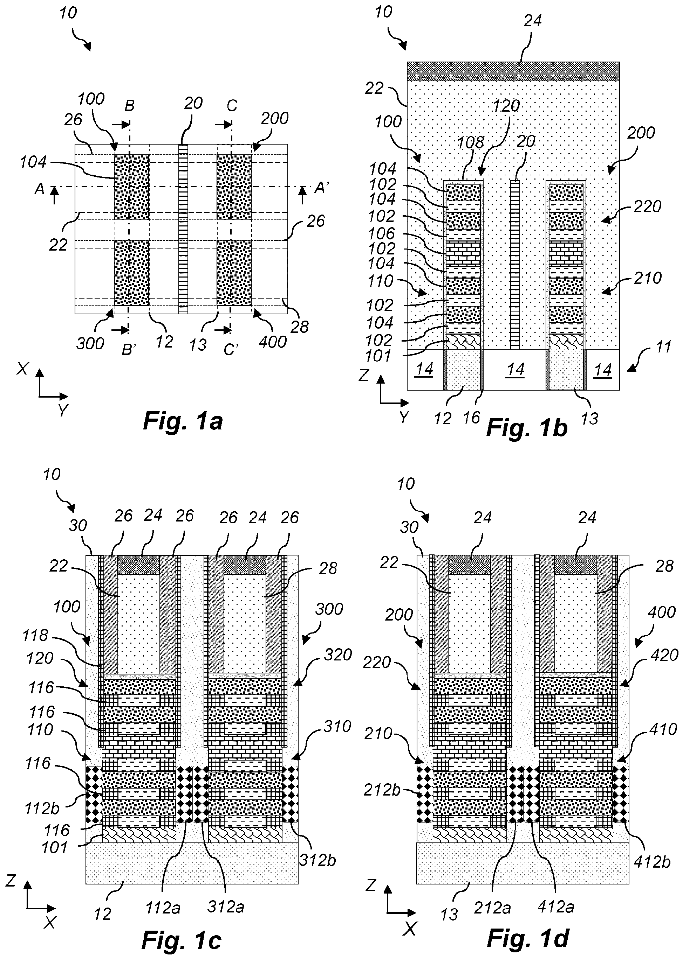

Fig. 1a-d to 12a-d illustrate steps of a method for forming a semiconductor device in accordance with an embodiment.

### Detailed description

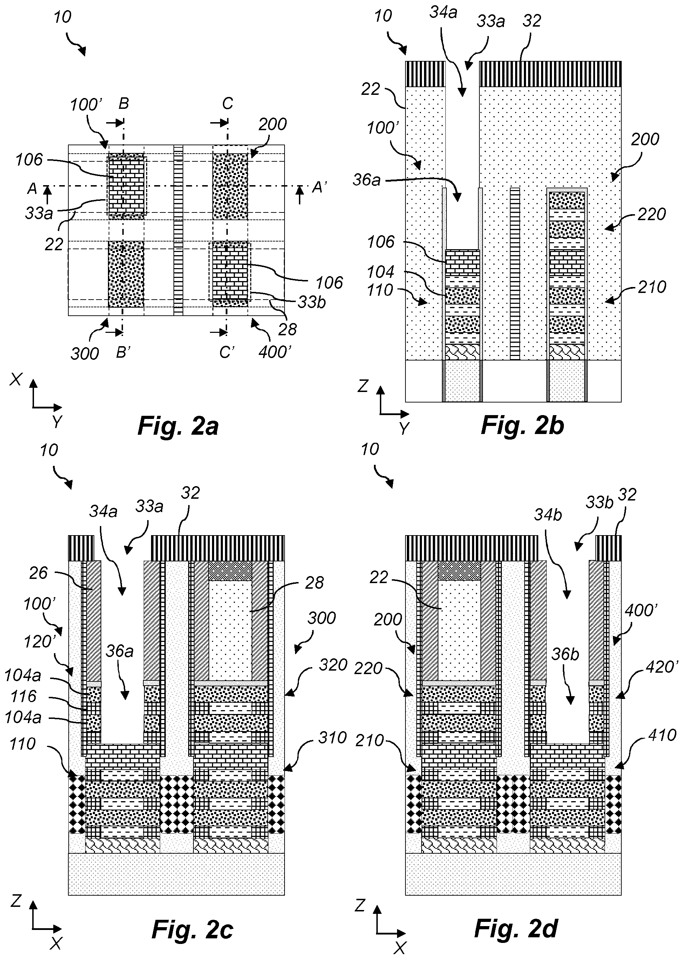

Methods for forming a semiconductor device will now be described with reference to Fig. 1a-d to 12a-d, schematically depicting a device structure 10 at different stages of fabrication. Fig. 1a shows a top-down view of the device structure 10. Fig. 1b shows a cross-sectional view along line A-A' indicated in Fig. 1a. Fig. 1c shows a cross-sectional view along line B-B' indicated in Fig. 1a. Fig. 1d shows a cross-sectional view along line C-C' indicated in Fig. 1a. Fig. 2a-d to 12a-d show corresponding views of the device structure 10. The X- and Y-axes indicate first and second transverse horizontal directions, parallel to a main plane of a substrate 11 of the device structure 10. The Z-axis indicates a normal or vertical direction with respect to the substrate 11. Throughout the figures, like fill patterns will be used for like materials, unless stated otherwise. While the method will be described and illustrated with reference to two pairs of bottom and top channel structures, along two parallel gate tracks, it is be noted that the method also is applicable to only a single pair of bottom and top channel structures, along a same gate track.

Fig. 1a-d shows the device structure 10 at an initial or starting stage of the method. A first, second, third and fourth initial stacked transistor structure 100, 200, 300 and 400 have been formed over the substrate 11, to be subjected to further processing steps as set out in the following to form final / functional transistor devices. The substrate 11 may be a conventional semiconductor substrate suitable for CMOS processing. The substrate 11 may be a single-layered semiconductor substrate, for instance formed by a bulk substrate such as a Si substrate, a germanium (Ge) substrate or a silicon-germanium (SiGe) substrate. A multi-layered / composite substrate is also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The first stacked transistor structure 100 comprises a first bottom channel structure 110 and a first top channel structure 120 stacked on top of the first bottom channel structure 110. The second stacked transistor structure 200 comprises a second bottom channel structure 210 and a second top channel structure 220 stacked on top of the second bottom channel structure 210. The third stacked transistor structure 300 comprises a third bottom channel structure 310 and a third top channel structure 320 stacked on top of the third bottom channel structure 310. The fourth stacked transistor structure 400 comprises a fourth bottom channel structure 410 and a fourth top channel structure 420 stacked on top of the fourth bottom channel structure 410.

The first bottom and top channel structures 110, 120 comprises a respective number of channel layers 104 and sacrificial layers 102 alternating the channel layers 104. Each sacrificial layer 102 and each channel layer 104 extends as shown along the X-direction, between a respective pair of opposite ends. For illustrative clarity the layers are indicated only for the first stacked transistor structure 100 but the further stacked transistor structures 200, 300, 400 each have a corresponding layer structure, as shown. It is to be noted that the illustrated numbers of sacrificial layers 102, and channel layers 104 are merely non-limiting examples, and the number of layers may be varied. While the bottom channel structures 110, 210, 310, 410 and top channel structures 120, 220, 320, 420 may comprise a different number of channel layers, typically, the bottom channel structures 110, 210, 310, 410 should have a same number of channel layers 104 (e.g. a *N₁* = 1, 2, 3, etc.) and the top channel structures 120, 220, 320, 420 should have same number of channel layers 104 (e.g. *N₂* = 1, 2, 3, etc. where *N₁* and *N₂* may be equal or different). This applies correspondingly to the number of sacrificial layers 102.

In the top-down view of Fig. 1a, layers and structures overlying the top channel layer 104 of each top channel structure 120, 220, 320, 420 have been omitted to allow a view of the relative locations of the first, second, third and fourth stacked transistor structures 100, 200, 300, 400. Meanwhile, base portions 12, 13 of first and second fin structures, first and second gate structures 22, 28 and a gate spacer 26 are schematically indicated with respective dashed outlines. In each of the top-down views to follow, an ILD layer 30 has been omitted.

The sacrificial layers 102 and the channel layers 104 may each be semiconductor layers formed of a sacrificial material and a channel material, respectively. The sacrificial material and the channel material may for instance be Si_{i1-y}Ge_{y} and Si₁₋ₓGeₓ respectively, wherein 0 ≤ x < y. For example, y may be equal to or greater than x + d, where d ≥ 0.25. In one example, the sacrificial material may be SiGe_{0.25} and the channel material may be a Si. As per se is known in the art, a relative difference in Ge-content enables subsequent selective processing (e.g. selective etching) of the sacrificial layers 102 and the channel layers 104. For example, a SiGe layer with a greater concentration of Ge than another Si or SiGe layer may be etched selectively (i.e. at a greater rate) using an HCl-based dry etch or an ammonia peroxide mixture (APM). Other appropriate etching processes (wet or dry) allowing selective etching of higher Ge-content SiGe layers with respect to lower Ge-content SiGe (or Si) layers are per se known in the art and may also be employed for this purpose.

The sacrificial layers 102 and the channel layers 104 may each be formed as nanosheets. For example, a nanosheet may have a thickness in a range of 5-15 nm, such as 10 nm, and a width in a range of 3-30 nm.

Each stacked transistor structure 100, 200, 300, 400 further comprises a dielectric separation layer 106 intermediate the bottom and top channel structures 110 and 120, 210 and 220, 310 and 320, 410 and 420. The dielectric separation layer 106 may for example be formed of an oxide- or nitride-based material, for instance of SiO₂, SiN, SiC, SiCO, SiCN or SiBCN or combinations thereof.

At the stage of the method shown in Fig. 1a-d, a pair of S/D structures 112a-b have been formed on the opposite ends of the channel layers 104 of the first bottom channel structure 110. Corresponding pairs of S/D structures 212a-b, 312a-b and 412a-b have as shown been formed on opposite ends of the channel layers 104 of each of the second, third and fourth bottom channel structures 210, 310, 410. It may be noted that according to the illustrated example, no S/D structures have yet been formed on the top channel structures 120, 220, 320, 420.

The pair of S/D structures 112a-b formed on the first bottom channel structure 110 may herein be referred to as the first pair of S/D structures 112a-b. The pair of S/D structures 212a-b formed on the second bottom channel structure 210 may herein be referred to as the second pair of S/D structures 212a-b. The pair of S/D structures 312a-b formed on the third bottom channel structure 310 may herein be referred to as the fourth pair of S/D structures 312a-b. The pair of S/D structures 412a-b formed on the fourth bottom channel structure 410 may herein be referred to as the sixth pair of S/D structures 412a-b. It is to be noted "first", "second" etc. in this context only are used as labels to facilitate individual referencing of the different pairs of S/D structures. Each S/D structure having a reference sign with the appendix "a" may in the following be referred to as "the first S/D structure" of the respective pair of S/D structures. Correspondingly, each S/D structure having a reference sign with appendix "b" may in the following be referred to as "the second S/D structure" of the respective pair of S/D structures. For conciseness, the pairs of S/D structures 112a-b, 212a-b, 312a-b and 412a-b may in the following be referred by the collective term "bottom S/D structures".

The bottom S/D structures may be formed as epitaxial (i.e. epitaxially grown) structures or bodies of doped semiconductor material (e.g. P-type or N-type Si or SiGe). As shown, each one of the bottom S/D structures may be formed by merged S/D portions formed on respective channel layers 104. The bottom S/D structures are hence depicted as continuous bodies. As shown in Fig. 1c, the first S/D structure 112a of the first pair of S/D structures 112a-b may further merge with the first S/D structure 312a of the fourth pair of S/D structures 312a-b. Correspondingly, as shown in Fig. 1d, the first S/D structure 212a of the second pair of S/D structures 212a-b may merge with the first S/D structure 412a of the sixth pair of S/D structures 412a-b.

Although omitted from Fig. 1a-d, to not overly obscure the drawings, the bottom S/D structures may be provided with a dielectric contact etch stop layer (ESL), such as an ALD-deposited nitride- or carbide-based material.

Each stacked transistor structure 100, 200, 300, 400 further comprises inner spacers 116, covering respective ends of the sacrificial layers 102 recessed with respect to the ends of the channel layers 104. The inner spacers 116 are formed by inner spacer material filling the recesses. Examples of inner spacer materials include dielectric materials, such as any of the materials mentioned in connection with the dielectric separation layer 106. As per se is known to the skilled person, inner spacers may serve to facilitate subsequent process steps, such as a channel release step wherein the inner spacers may counteract etching of the S/D structures (e.g. 112a-b) during removal of the sacrificial layers 102.

A temporary cover spacer 118 has been formed to cover the sidewalls of the top channel structures 120, 220, 320, 420. The cover spacer 118 may facilitate selective forming of the bottom S/D structures by acting as an epitaxy mask for the ends of the channel layers 104 of the top channel structures 120, 220, 320, 420 during the bottom S/D epitaxy. The cover spacer 118 may for instance be formed by forming a temporary block mask covering the sidewalls of the bottom channel structures 110, 210, 310, 410 and then conformally depositing a cover spacer material over the device structure 10. The cover spacer material may then be etched anisotropically (e.g. top-down) to remove the cover spacer material from horizontally oriented surfaces of the device structure 10, including an upper surface of the block mask, such that the cover spacer material remains to form the cover spacer 118 on vertically oriented sidewalls of the device structure 10, as shown in Fig. 1. The block mask may then be removed using a suitable etching process. As indicated by the similar fill patterns for the inner spacers 116 and the cover spacer 118, the inner spacers 116 and the cover spacer 118 may be formed of a same material, although different materials are also possible.

Forming the device structure 10 comprises forming the first and third bottom and top channel structures 110, 120, 310, 320 of the first and third stacked transistor structures 100, 300 along a first fin structure, and forming the second and fourth bottom and top channel structures 210, 220, 410, 420 of the second and fourth stacked transistor structures 100, 300 along a second fin structure parallel to the first fin structure. Reference signs 12 and 13 indicate a respective base portion of the first and second fin structures remaining after forming the stacked transistor structures 100, 200, 300, 400. The base portions 12, 13 define fin-shaped portions of the substrate 11 (e.g. of Si), protruding in the Z-direction and extending along the X-direction. The base portions 12, 13 are surrounded by a shallow-trench isolation (STI) oxide 14, e.g. of SiO₂ or another conventional low-k dielectric suitable as STI. Additionally, a dielectric liner 16 (e.g. of a nitride such as SiN) may as shown be formed on sidewalls of the base portions 12, 13.

The bottom channel structures 110, 210, 310, 410 may as shown be separated from the respective base portions 12, 13 by a bottom dielectric layer 101. Suitable materials for the bottom dielectric layer 101 include oxide and nitride materials, e.g. SiO₂, SiN, SiC, SiCO, SiCN, SiBCN or combinations thereof. A bottom dielectric layer 101 allows providing an improved isolation between the substrate 11 (e.g. the base portions 12, 13) and the bottom channel structures 110, 210, 310, 410.

A first sacrificial gate 22 has been formed to extend across the first and second bottom and top channel structures 110, 120, 210, 220. A second sacrificial gate 28 has been formed to extend across the third and fourth bottom and top channel structures 310, 320, 410, 420. The first and second sacrificial gates 22, 28 extend in parallel, along the Y-direction. Suitable materials for the sacrificial gates 22, 28 include for instance amorphous Si. A gate hard mask layer 24 (e.g. remaining from sacrificial gate patterning discussed below) is formed on top of the first and second sacrificial gates 22, 28. The gate hard mask layer 24 may also be referred to as a sacrificial gate cap 24. Suitable materials for the gate hard mask layer 24 include for instance SiN, SiC, SiCO, SiCN, SiBCN. Further, a gate spacer 26 is formed on and along respective opposite sidewalls of the sacrificial gates 22, 28. Suitable materials for the gate spacer 26 include for instance SiN, SiC, SiCO, SiCN or SiBCN, or combinations thereof. The gate spacer 26 may be formed of a different material than the gate hard mask layer 24 to facilitate etching of the gate hard mask layer 24 selectively to the gate spacer 26 during later process steps.

A dummy gate oxide 108 may as shown be formed on each stacked transistor structures 100, 200, 300, 400 of e.g. an oxide such as a thermal oxide or a conformally deposited oxide, e.g. SiO₂ deposited by atomic layer deposition (ALD) prior to forming the sacrificial gates 22, 28.

The device structure 10 has further been provided with an interlayer dielectric (ILD) layer 30 covering the bottom S/D structures and surrounding the sacrificial gates 22, 28 on either side. The ILD layer 30 may be formed of an insulating material, such as an oxide, e.g. SiO₂, or another conventional low-k dielectric suitable as interlayer dielectric.

The device structure 10 may as shown further comprise a vertically oriented dielectric wall 20, formed at a position between the first and second fin structures and extending along the X direction. Suitable materials for the dielectric wall 20 include for instance SiN, SiC, SiCO, SiCN SiBCN. The dielectric wall 20 may as will be better understood from the following facilitate a subsequent gate cut process. The dielectric wall 20 is however an optional feature and may be omitted.

Fabrication of the device structure 10 as shown in Fig. 1a-d may proceed as follows:
A first and second fin structure (e.g. a plurality of parallel fin structures) may be patterned in an initial layer stack comprising an initial bottom layer sub-stack (for forming the bottom channel structures 110, 210, 310, 410) and an initial top layer sub-stack (for forming the top channel structures 120, 220, 320, 420). The layers may be epitaxially grown using deposition techniques such as chemical vapor deposition (CVD) or physical vapor deposition (PVD). Conventional fin patterning techniques may be used, e.g. single patterning techniques such as lithography and etching ("litho-etch") or multiple-patterning techniques such as (litho-etch)^{x}, self-aligned double or quadruple patterning (SADP or SAQP).

The dielectric separation layer 106 may be formed using a sacrificial layer replacement process, wherein an intermediate sacrificial layer of the fin structures (e.g. after fin patterning, such as prior to or subsequent to forming the sacrificial gates 22, 28) may be replaced with a dielectric material by removing the intermediate sacrificial layer in a selective etching process and refilling the thusly formed cavity in the fin structure with a dielectric using a conformal deposition process such as ALD. For example, in case of a Si/SiGe-based layer stack, the intermediate sacrificial layer may be formed of SiGe with a higher Ge-content than the further sacrificial layers 102 (e.g. of Si_{1-z}Ge_{z}, where z > y, such as z = y + d). The dielectric separation layer 106 may also be formed by patterning fin structures in an initial layer stack wherein the initial top device sub-stack may be formed on a separate wafer and subsequently be transferred and bonded to an initial dielectric separation layer using a wafer transfer and bonding process. The initial dielectric separation layer then be patterned together with the bottom and top device sub-stacks to form the dielectric separation layer 106.

The fin structures may subsequently be covered by insulating material which may be recessed, e.g. by chemical mechanical polishing (CMP) and/or etch back, to expose the fin structures and form the STI 14 surrounding the respective base portions 12, 13 of the fin structures. An oxide may then be deposited over the fin structure(s) form the dummy gate oxide 108.

The fabrication may then proceed with sacrificial gate structure formation. A sacrificial gate layer (e.g. amorphous Si) may be deposited over the fin structures (e.g. using CVD or PVD). The sacrificial gates 22, 28 (e.g. a plurality of parallel sacrificial gates) may then be patterned therein using single- or multiple-patterning techniques, as per se is known in the art. A hard mask used during the sacrificial gate layer patterning may be preserved on top of the sacrificial gates 22, 28 to form the gate hard mask layer 24. The gate spacer 26 may subsequently be formed by depositing a gate spacer material (e.g. using ALD). The gate spacer material may then be etched anisotropically (e.g. top-down) to remove the gate spacer material from horizontally oriented surfaces of the device structure 10 such that the gate spacer material remains on the vertically oriented sidewalls of the sacrificial gates 22, 28 and gate hard mask layer 24.

The fin structures may subsequently be recessed by etching back the fin structures in a top-down direction on either side of each sacrificial gate 22, 28. Each fin structure may thereby be partitioned into a plurality of stacked transistor structures 100, 200, 300, 400 each comprising a respective bottom channel structure 110, 210, 310, 410 and top channel structure 120, 220, 320, 420 and dielectric separation layer 106. The etch-back may proceed through the fin structures, stopping at the base portions 12, 13 and thus define ends or end surfaces of the respective sacrificial layers 102 and channel layers 104 on either side of each sacrificial gate 22, 28.

The bottom dielectric layers 101 may be formed for instance by replacing a bottom-most sacrificial layer of the fin structures with a dielectric layer. In a Si/SiGe-based fin structure, a bottom-most sacrificial layer may for instance be formed of SiGe with a higher Ge-content than the sacrificial layers 102, such that the bottom-most sacrificial layer may be removed employing a selective etching process. Cavities may thus be formed which may be filled with one or more dielectric material to form the bottom dielectric layers 101. The replacement process may be conducted, for instance after patterning the fin structures and prior to recessing the fin structures, or after recessing the fin structures.

The dielectric wall 20 may be formed prior to forming the sacrificial gates, for instance using a tone-inverted approach, wherein a temporary mask material (e.g. an organic spin-on material such as SOC) may be deposited to cover the fin structures and the substrate 11. Following patterning of a wall trench in the SOC, the wall trench may be filled with one or more dielectric materials to form the dielectric wall 20. After removing overburden dielectric material from the temporary mask layer (e.g. by CMP) the temporary mask layer may be removed to reveal the dielectric wall 20.

Prior to forming the bottom S/D structures, the inner spacers 116 may be formed using an inner spacer formation process. An inner spacer formation process may comprise forming recesses using a lateral etch back (e.g. along the X- and negative X-directions) of the ends or end surfaces of each sacrificial layer 102 from opposite sides of the sacrificial gates 22, 28 using an isotropic etching process (e.g. selective to the sacrificial material). Inner spacer material may be deposited with a thickness such that the recesses are pinched-off (i.e. closed) by the spacer material. The inner spacer material may for example be deposited using conformal deposition techniques such as ALD. Portions of inner spacer material deposited outside the recesses may subsequently be removed using a suitable etching process (anisotropic or isotropic, wet or dry) to expose end surfaces of the channel layers 104.

The bottom S/D structures may then be formed, using an epitaxial process, on the ends or end surfaces of the respective channel layers 104 of the bottom channel structures 110, 210, 310, 410. As mentioned above, the cover spacer 118 may be used to facilitate area selective epitaxy at the bottom channel structures 110, 210, 310, 410.

Subsequent to forming the bottom S/D structures, an insulating material may be deposited (e.g. SiO₂ deposited by flowable-CVD) and recessed (e.g. by CMP and/or etch back) to form the ILD layer 30, as shown in Fig. 1.

While in the illustrated example, both the bottom and top channel structures comprise sacrificial layers 102, the method is applicable also to channel structures with other layer structures. For example, the bottom channel structures 110, 210, 310, 410 and/or the top channel structures 120, 220, 320, 420 may comprise only a single channel layer and no sacrificial layers. This structure may be useful for forming bottom and/or top devices with only a single channel layer and without a gate-all-around. In a bottom and/or device channel structure without sacrificial layers, inner spacers may be omitted, as would be understood by the skilled person.

In Fig. 2a-d, a mask layer 32 (e.g. a hard mask) has been formed over the device structure 10 and patterned to define a first mask opening 33a overlying the first top channel structure 120 and a second mask opening 33b overlying the fourth top channel structure 420. Fig. 2a schematically indicates the locations of the mask openings 33a-b with a dashed outline. The mask openings 33a-b may be patterned using a conventional lithography and etching process. The openings 33a-b have subsequently been transferred into the first and second sacrificial gates 22, 28, respectively, to define a first opening 34a in the first sacrificial gate 22 and a second opening 34b in the second sacrificial gate 28. The first opening 34a is formed to selectively expose a top surface portion of the first top channel structure 120. The second opening 34b is formed to selectively expose a top surface portion of the fourth top channel structure 420. In the illustrated example each exposed top surface portion is formed by a respective portion of a top surface of the topmost channel layer 104 of the first and fourth top channel structures 120, 420. However, the exposed top surface portion may also be formed by a portion of a top-most sacrificial layer 102, in case a sacrificial layer 102 forms a top-most layer of the top channel structures 120, 420. As shown, in case the dummy gate oxide 108 is present, an additional separate etch step to open the dummy gate oxide 108 and reveal the top surface portion of the top channel structures 120, 420 may be needed.

Subsequently, a first cut 36a has been formed through the first top channel structure 120 by etching the first top channel structure 120 from the opening 33a in the first sacrificial gate 22. The etching and thus the cut 36a extends through each of the channel layers 104 and the sacrificial layers 102 of the first top channel structure 120 and is stopped over the first bottom channel structure 110. The first cut 36a may be etched using a suitable etching process, isotropic or anisotropic, wet or dry. By the selective opening of the sacrificial gate 22, portions of the sacrificial gate 22 may as shown remain along sidewalls of the first bottom and top device channel structures 110, 120 after forming the opening 34a. The remaining portions of the sacrificial gate 22 may thus be used as an etch mask for the first bottom channel structure 110 during the forming of the cut 36a. Meanwhile, the dielectric separation layer 106 may act as an etch mask, masking the first bottom channel structure 110 from above. The dielectric separation layer 106 may in particular be used as an etch stop layer. It is however also possible to stop the etching of the cut 36a prior to the dielectric separation layer 106, such as on or within a bottom-most one of the sacrificial layers 102 of the first top channel structure 120. In any case, the etching does not extend into the first bottom channel structure 110 and the channel layers 104 thereof are hence preserved underneath the cut 36a.

By forming the cut 36a, the channel layers 104 of the first top channel structure 120 may accordingly be cut or removed (at least partially) such that forming an active top transistor during subsequent process steps is prevented. As the cut 36a is formed via the opening 34a, the cut 36a may be self-aligned to an active region or channel region of the first stacked transistor structure 100. More specifically, the channel layers 104 of the first top channel structure 110 may be cut in a region in which otherwise an active region of a top transistor may be formed.

The above discussion concerning forming of the opening 34a in the first sacrificial gate 22, and the cut 36a through the first top channel structure 120, applies correspondingly to forming of the opening 34b in the second sacrificial gate 28, and the cut 36b through the fourth top channel structure 420, as is readily apparent from Fig. 2d.

By forming the cuts 36a-b, the initially first and fourth stacked transistor structures 100, 400 have been processed to define respective non-stacked transistor structures 100', 400', adjacent the second and third stacked transistor structures 200, 300. The respective cut top channel structures are designated by their original reference signs appended by a " ' ".

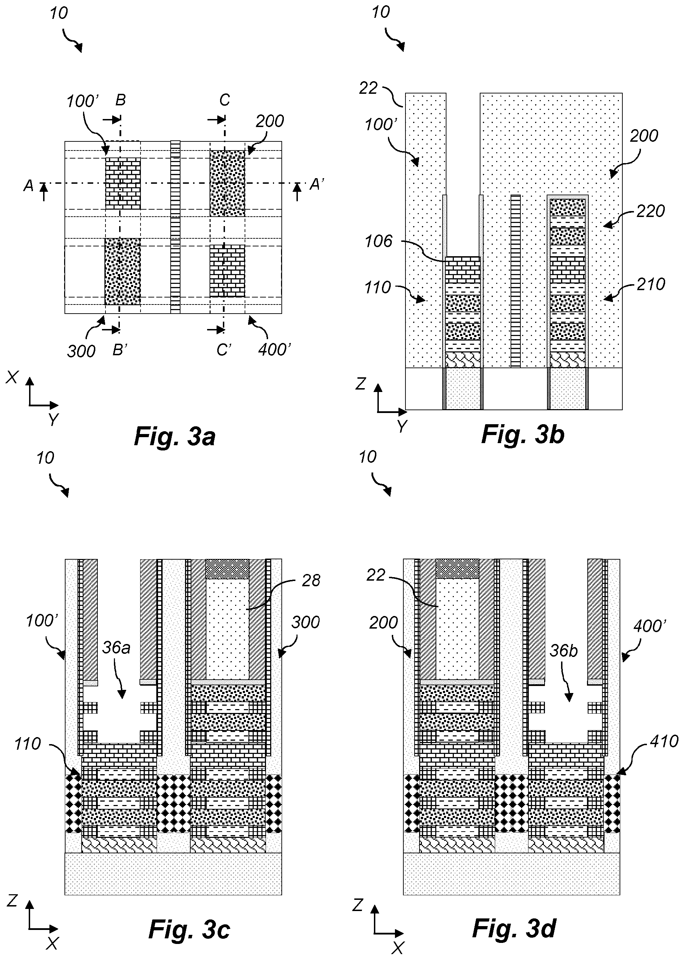

In Fig. 3a-d, portions of channel material of the channel layers 104 of the first top channel structure 120' and the fourth channel structure 420' remaining after forming the cuts 36a-b have been removed using an isotropic etching process. Remaining portions of channel material may include end portions 104a of the channel layers 104 (see Fig. 2c-d) masked by and thus preserved underneath the gate spacer 26 and the inner spacers 116. The remaining portions of the sacrificial gate 22 and 28 may be used as an etch mask (together with the dielectric separation layer 106) for the first and fourth bottom channel structures 110, 410 also during the isotropic etching process. The mask layer 32 may be removed prior to or after conducting the isotropic etching process.

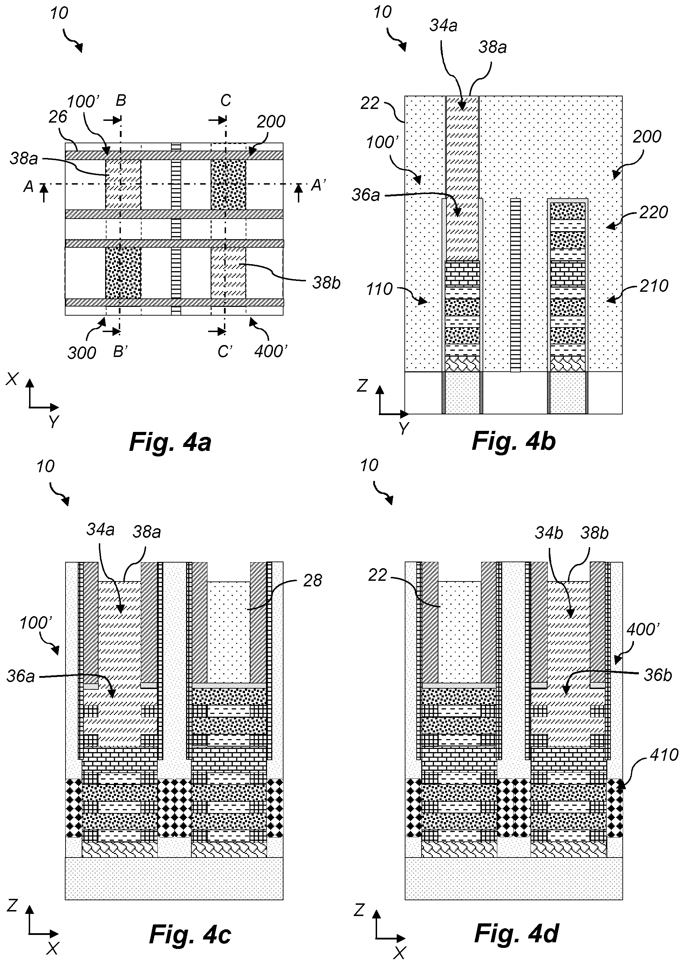

In Fig. 4a-d, the openings 34a-b and the cuts 36a-b have been filled or "plugged" with a dielectric fill material (e.g. any of the materials mentioned in connection with the sacrificial gate cap 24). A first dielectric plug 38a is hence formed in the opening 34a and the cut 36a. A second dielectric plug 38b is formed in the opening 34b and the cut 36b. The fill material may be conformally deposited (e.g. using ALD) to facilitate a high fill ratio. Overburden dielectric fill material may be removed from the device structure 10 in a planarization process, comprising e.g. CMP. The dielectric plugs 38a-b may further optionally be recessed to a level substantially coinciding with a top surface of the sacrificial gates 22, 28. The sacrificial gate cap 24 may be removed from the sacrificial gates 22, 28 prior to forming the dielectric plugs 38a-b, e.g. employing an etching process selective to the hard mask material of the sacrificial gate cap 24. From Fig. 4a and onwards, the gate spacer 26 is no longer shown as transparent.

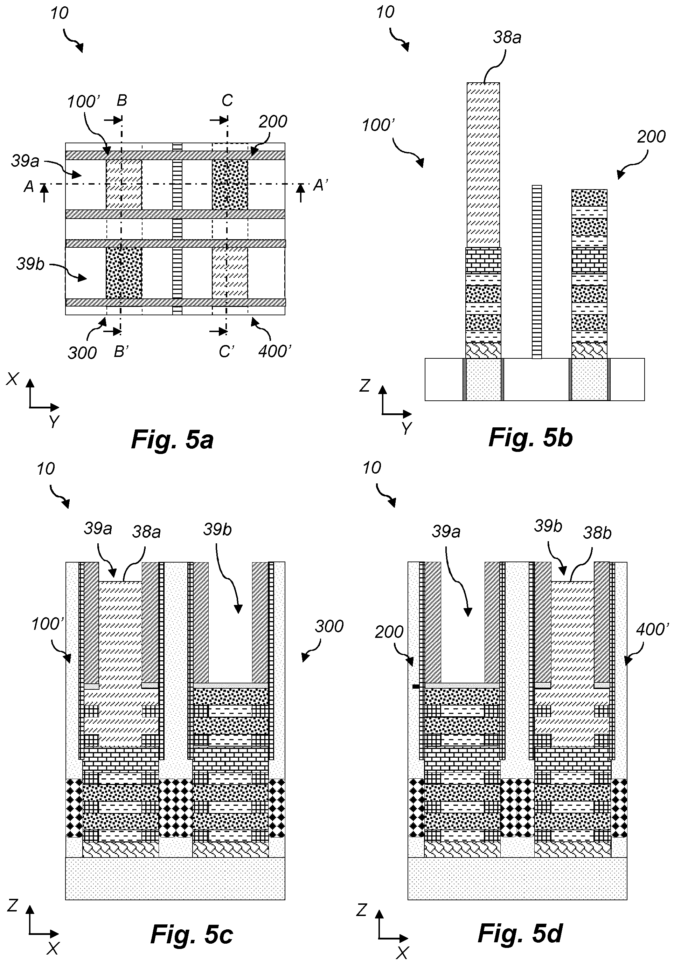

In Fig. 5a-d the non-stacked transistor structures 100', 400' and the stacked transistor structures 200, 300 have been exposed by removing remaining portions of the sacrificial gates 22, 28, e.g. employing an isotropic etching process selective to the material of the sacrificial gates 22, 28 (e.g. a-Si). The removal of the sacrificial gates 22, 28 may be preceded by an initial etch step to remove the sacrificial gate cap 24. An additional etch step may be applied to remove the dummy gate oxide 108, if present. Removing the first sacrificial gate 22 defines a first gate trench 39a comprising the first non-stacked transistor structure 100' and the second stacked transistor structure 200. Removing the second sacrificial gate 28 defines a second gate trench 39b comprising the fourth non-stacked transistor structure 400' and the third stacked transistor structure 300.

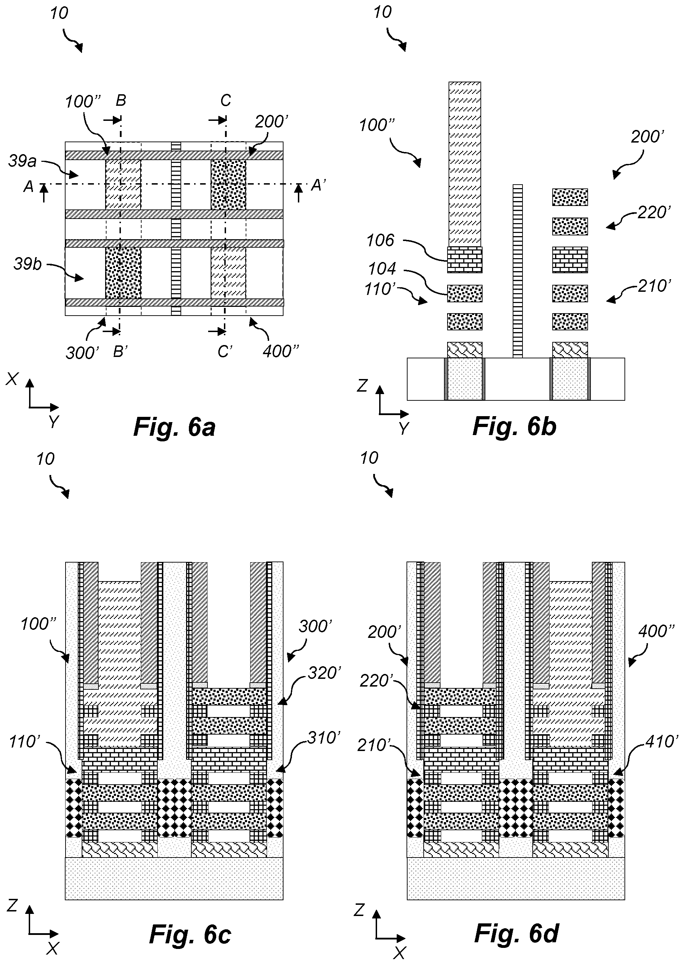

In Fig. 6a-d the sacrificial layers 102 have been removed from the non-stacked transistor structures 100', 400' and the stacked transistor structures 200, 300 by etching the sacrificial material selectively to the channel material within the gate trenches 39a-b, thereby "releasing" the channel layers 104 of the channel structures of the respective transistor structures 100', 200, 300, 400'. The transistor structures after conducting the channel release are designated 100", 200', 300' and 400", wherein the respective "released" channel structures thereof are designated by their original reference signs appended by a " ' ", as shown in Fig. 6a-d. During the etching of the sacrificial material, the inner spacers 116 may act as an etch mask for the bottom S/D structures.

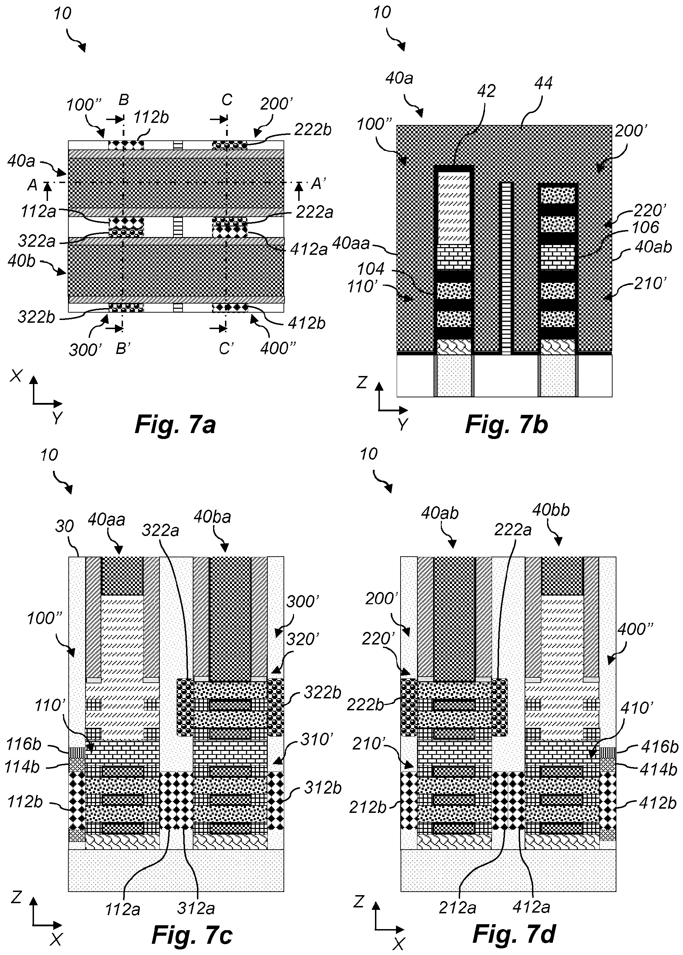

In Fig. 7a-d a first replacement metal gate (RMG) structure 40a has been formed in the first gate trench 39a and a second RMG structure 40b has been formed in the second gate trench 39b.

The first RMG structure 40a comprises a first gate stack 40aa or gate stack portion formed on the first bottom channel structure 110' of the first non-stacked transistor structure 100" and a second gate stack 40ab or gate stack portion formed on the second bottom and top channel structures 210', 220' of the second stacked transistor structure 200'.

The second RMG structure 40b comprises a third gate stack 40ba or gate stack portion formed on the third bottom and top channel structures 310', 320' of the third stacked transistor structure 300', and a fourth gate stack 40bb or gate stack portion formed on the fourth bottom channel structure 410' of the fourth non-stacked transistor structure 400".

The first and second RMG structures 40a-b may be formed by conformally depositing a gate dielectric layer (not individually shown in Fig. 7a-d) and then a gate work function metal (WFM) 42 (e.g. using ALD) on and around the channel layers 104 in the gate trenches 39a-b. Suitable materials for the gate dielectric layer include for instance a conventional a high-k dielectric e.g. HfO₂, HfSiO, LaO, AlO or ZrO. Suitable WFMs include one or more effective WFMs such as n-type WFMs (e.g. TiAl or TiAlC) and/or P-type WFMs (e.g. TiN or TaN). A gate fill metal 44 (such as W, Al, Co or Ru) may then be deposited to fill a remaining space of the gate trenches 39a-b. The gate fill metal 44 may for instance be deposited by CVD or PVD and subsequently be planarized and recessed (e.g. by CMP and/or metal etch back) to remove portions of the gate stack deposited outside the gate trenches 39a-b and expose an upper surface of the ILD layer 30.

At this stage of the method the first and second RMG structures 40a-b both extend across and over the dielectric wall 20 such that the respective gate stack portions are connected over the dielectric wall 20.

Fig. 7a-d schematically depict the first and second RMG structures 40a-b as having a same type of WFM at the bottom and top channel structures (e.g. the second gate stack 40ab on the second stacked transistor structure 200' and the third gate stack 40ba on the third stacked transistor structure 300'). However, as may be appreciated by the skilled person, the first and second RMG structures 40a-b may be formed employing a CMOS-RMG / dual WFM process, for optimizing the performance of bottom and top transistors of different conductivity types. Gate stacks with different effective WFMs for the bottom and top channel structures may thus be formed. For instance, the second gate stack 40ab of the first RMG structure 40a may comprise a lower gate sub-stack surrounding the second bottom channel structure 210' and an upper gate sub-stack surrounding the second top channel structure 220', wherein the first gate stack 40aa and the lower gate sub-stack may be an N-type gate and the upper gate sub-stack may be a P-type gate stack, or vice versa. This may apply correspondingly to the third and fourth gate stacks of the second RMG structure 40b.

In a CMOS-RMG process, a first WFM (conformally deposited) may be removed selectively from the top channel structures 220', 320' using an isotropic metal etch process while masking the first WFM formed on the bottom channel structures 110', 210', 310', 410' layers using a block mask layer. A block mask layer may for instance be formed by depositing mask material in the gate trenches 39a-b and etching back the mask material such that the first WFM on the top channel structures 220', 320' is exposed and remains covered on the bottom channel structures 110', 210', 310', 410'. The mask material may for instance be etched back to a level coinciding with the dielectric separation layer 106. The mask material may be an organic material deposited using a CVD or spin-on process (e.g. an organic spin-on-layer such as SOC). After removing the bottom mask layer, a second WFM, or a stack of WFMs, may be deposited on the first WFM remaining on the bottom channel structures 110', 210', 310', 410', and on the gate dielectric layer on the top channel structures 220', 320'. The RMG structure formation may then proceed by depositing the gate fill metal 44.

Still with reference to Fig. 7a-d, a pair of S/D structures 222a-b has been formed on the second top channel structure 220' and a pair of S/D structures 322a-b has been formed on the third top channel structure 320'. The pair of S/D structures 222a-b formed on the second top channel structure 220' may herein be referred to as the third pair of S/D structures 222a-b. The pair of S/D structures 322a-b formed on the third top channel structure 320' may herein be referred to as the fifth pair of S/D structures 322a-b. For conciseness, the third and fifth pairs of S/D structures 222a-b and 322a-b may in the following be referred by the collective term "top S/D structures".

The top S/D structures may like the bottom S/D structures be formed as epitaxial (i.e. epitaxially grown) structures or bodies of doped semiconductor material (e.g. P-type or N-type Si or SiGe). To form CFETs, the bottom and top S/D structures should be formed with opposite conductivity types. The top S/D structures may be formed by patterning S/D trenches in the ILD layer 30, along the ends of the channel layers 104 of the top channel structures 220', 320'. As may be appreciated, the trenches should be formed not to expose the bottom S/D structures. If still present, the cover spacer 118 needs to be removed by an isotropic etch prior to the S/D epitaxy. After completing the top S/D epitaxy, the S/D trenches may be refilled with ILD to restore the ILD layer 30. The top S/D structures may like bottom S/D structures be provided with a dielectric contact ESL prior to depositing the ILD.

As any remaining portions of channel material have been removed from the first and fourth top channel structures 120', 420' as discussed in connection with Fig. 3a-d above, there are no seeding surfaces for the top S/D epitaxy over the first and fourth bottom channel structures 110', 410'. As shown in Fig. 7c-d, the top S/D structures may hence be formed selectively on the uncut channel layers 104 of the top channel structures 210', 310'. Hence, there is no corresponding top S/D structure of the non-stacked transistor structures 100", 200" which the first top S/D structures 222a, 322a may merge with. It is however to be noted that the removal of remaining portions of channel material is an optional step, which may be omitted, in particular at relaxed gate pitches where there merging of top S/D structures may be avoided (e.g. due to the greater separation between adjacent top channel structures) or acceptable (e.g. due to a greater available space for the top S/D contacts).

At the stage of the method depicted in Fig. 7a-d, (second) bottom S/D contacts 114b and 414b have additionally been formed on the second S/D structures 112b, 412b. The bottom S/D contacts 114b, 414b are omitted from Fig. 7a to allow a view of the S/D structures 112b, 412b underneath. The bottom S/D contacts 114b, 414b may be formed prior to the top S/D epitaxy. For example, the bottom S/D contacts 114b, 414b may be formed by etching contact trenches in the ILD layer 30 (e.g. using a standard lithography and etching process). The contact trenches may be formed with a depth to expose at least an upper portion of the second S/D structures 112b, 412b. To complete the contact trench formation, a separate etch step may be applied to open the contact ESL, if present on the second S/D structures 112b, 412b. One or more contact metals may then be deposited on the second S/D structures 112b, 412b and to fill the contact trenches. Suitable contact metals include a fill metal such as W, Co, Ni, Mo, Ru, or combinations thereof. The fill metal may be deposited for instance using CVD, PVD or plating. Deposition of the fill metal(s) may be preceded by conformal deposition (e.g. using ALD) of a diffusion barrier layer (e.g. Ti or TiN) and/or a seed layer to facilitate the subsequent filling of the contact trenches with the one or more contact metals. After filling the contact trenches, overburden contact metal (i.e. contact metal deposited outside the contact trenches) may be removed using a planarization process comprising e.g. CMP and/or metal etch back. The contact metal may further be recessed in the contact trenches to form the bottom S/D contacts 114b, 414b with a desired height. An insulating material (e.g. SiO₂) may then be deposited in the contact trenches, to cover the bottom S/D contacts 114b, 414b and restore the ILD layer 30. For an improved contact separation, the bottom S/D contacts 114b, 414b may as shown be covered with a separate dielectric contact capping layer 116b, 416b capping the bottom S/D contacts 114b, 414b. Suitable materials for the dielectric contact capping layer 116b, 416b include for instance SiN, SiCO, or SiOCN. The dielectric contact material may be deposited in the contact trenches and etched back (e.g. employing an etch selective to the dielectric contact material) to form the dielectric contact capping layer 116b, 416b with a desired thickness. Although in the illustrated example, bottom S/D contacts are formed only on the second S/D structures 112b, 412b, it is also possible to form bottom S/D contacts on each of the bottom S/D structures.

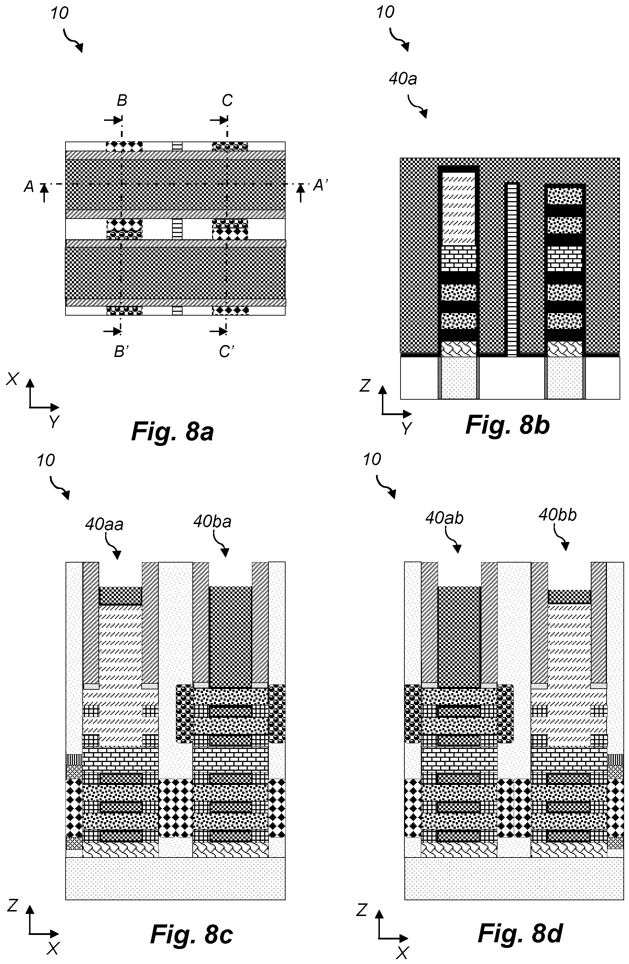

In Fig. 8a-d the first and second RMG structures 40a-b have been recessed employing a metal etch back.

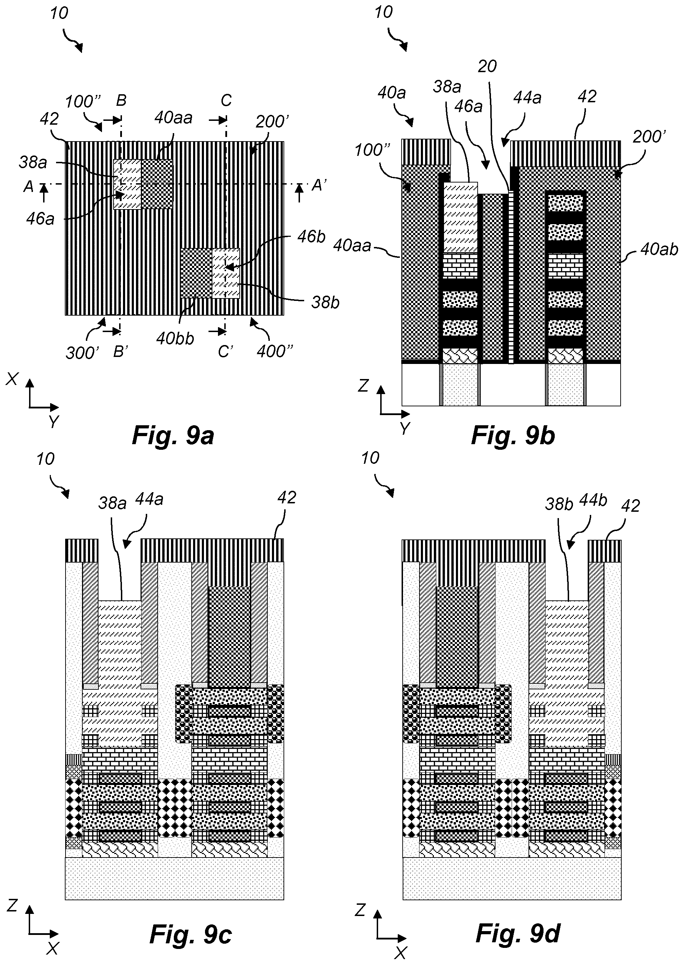

In Fig. 9a-d, a gate cut mask layer 42 has been formed over the device structure 10 and patterned to define a first mask opening 44a overlying the dielectric wall 20 and the first RMG structure 40a, and a second mask opening 44b overlying the dielectric wall 20 and the second RMG structure 40b. While depicted as a single material layer, the gate cut mask layer 42 may be a standard lithographic layer stack, for instance a spin-on-carbon/spin-on-glass (SOG/SOC) stack with a resist layer on top. An initial opening may be patterned in the resist layer using a lithography process and then be transferred into the SOC, for instance using an anisotropic etch (top-down). The openings 44a-b have subsequently been transferred into the first and second RMG structures 40a-b, to form a first cut 46a and second cut 46b in the first and second RMG structures 40a-b, each cut landing on a top of the dielectric wall 20 and a respective one of the dielectric plugs 38a-b. The gate cut mask layer 42 may subsequently be removed. A conventional metal etching process, wet or dry, isotropic or anisotropic, may be used to form the cuts 46a-b.

The first cut 46a disconnects the first gate stack 40aa from the second gate stack 40ab of the first RMG structure 40a. The second cut 46b disconnects the third gate stack 40ba from the fourth gate stack 40bb of the second RMG structure 40b. The merits of the dielectric wall 20 hereby becomes apparent in the cuts 46a-b only need to be etched to a top of the dielectric wall 20. If the device structure 10 has not been provided with a dielectric wall, the cutting of the first and second RMG structures 40a-b may be achieved by a high-aspect-ratio trench etch and thereafter filling the trench with a dielectric material to form a dielectric wall between the first and second gate stacks, and the third and fourth gate stacks, respectively.

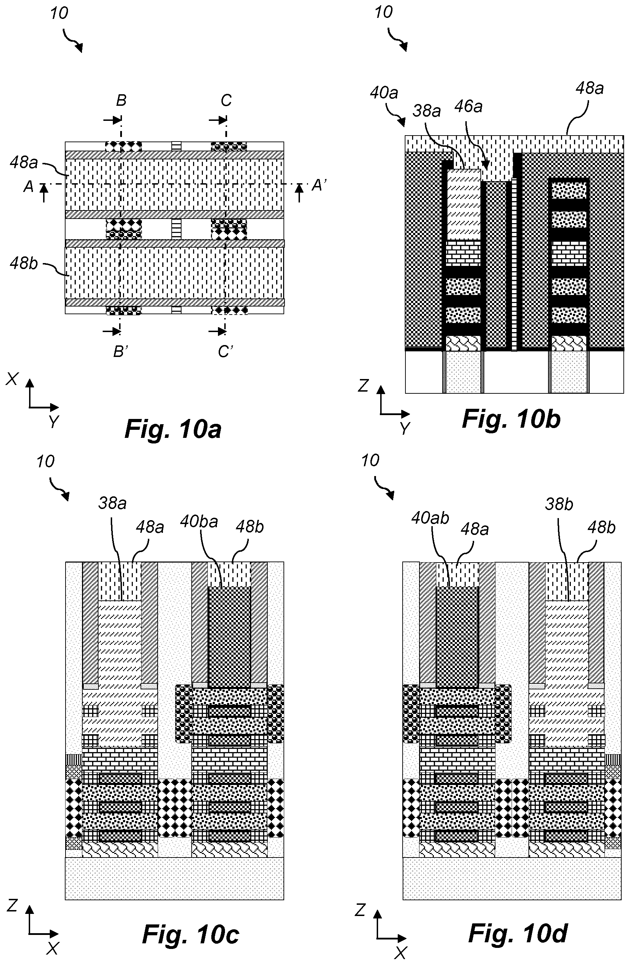

In Fig. 10a-d a dielectric gate capping material has been deposited to fill the cuts 46a-b and cover the cut RMG structures 40a-b and the dielectric plugs 38a-b. Suitable capping materials include for instance SiO₂, SiN, SiCO, or SiOCN, e.g. deposited by CVD or PVD. The dielectric gate capping material may subsequently be subjected to a planarization process (e.g. CMP and/or etch back) to remove overburden capping material and thus form a first dielectric gate capping layer 48a (or shorter first gate cap 48a) over the first RMG structure 40a and the first dielectric plug 38a, and a second dielectric gate capping layer 48b (or shorter second gate cap 48b) over the second RMG structure 40b and the second dielectric plug 38b.

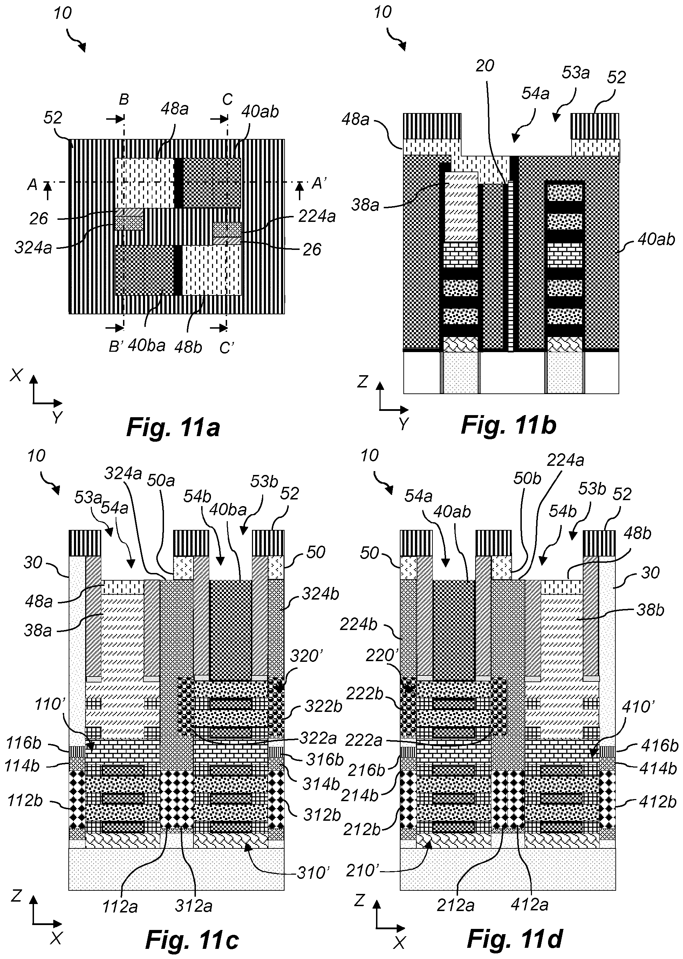

In Fig. 11a-d further S/D contacts have been formed. The further S/D contacts comprises a pair of S/D contacts 324a-b on the pair of S/D structures 322a-b. A first S/D contact 324a of the pair of S/D contacts 324a-b is formed on the merged first S/D structures 112a, 312a (on the first and third bottom channel structures 110', 310') and on the first top S/D structure 322a (on the third top channel structure 320'). The first S/D contact 324a may thus be referred to as a first common S/D contact 324a, interconnecting the first bottom S/D structures 112a, 312a and the first top S/D structure 322a. A corresponding pair of S/D contacts 224a-b is formed on the pair of S/D structures 222a-b on the second top channel structure 220'. A first S/D contact 224a of the pair of S/D contacts 224a-b is formed on the merged first S/D structures 212a, 412a (on the second and fourth bottom channel structures 210', 410') and on the first top S/D structure 222a (on the second top channel structure 220'). The first S/D contact 224a may thus be referred to as a second common S/D contact 224a, interconnecting the first bottom S/D structures 212a, 412a and the first top S/D structure 222a. Meanwhile, the second (top) S/D contacts 224b and 324b of the respective pairs of S/D contacts 224a-b and 324a-b are formed to be separated (along the Z-direction) and thus disconnected from the respective second bottom S/D contacts 214b, 314b. More specifically, the second top S/D contacts 224b and 324b may as shown be separated from the respective second bottom S/D contacts 214b, 314b by a portion of ILD layer 30 and/or a dielectric contact capping layer 216b, 316b (corresponding to capping layer 116b, 416b).

As may be seen in Fig. 11b-d, the respective top surfaces of the first and second common S/D contacts 324a, 224a and the second and fourth gate stacks 40ab, 40bb may be located at a level above the top surface of the dielectric plugs 38a-b. This facilitates ensuring that later formed trenches 54a, 54b for cross-couple contacts (see below) do not expose the first gate stack 40aa underneath the dielectric plug 38a or the fourth gate stack 40bb underneath the dielectric plug 38b.

The pairs of S/D contacts 224a-b, 324a-b may be formed in a similar manner as the bottom S/D contacts 114b, 414b. Contact trenches may be etched in the ILD layer 30 and filled with one or more contact metals (e.g. after opening the contact ESL if present). The contact trenches for the first and second common S/D contacts 324a, 224a may be formed in a first lithography and etching process and the contact trenches for the second top S/D contacts 224b, 324b in a second lithography and etching process. The contact trenches for the first and second common S/D contacts 324a, 224a may be formed with a depth to expose at least an upper portion of the respective merged first S/D structures 122a, 312a and 212a, 412a. Alternatively, if S/D contacts already have been formed on the merged first S/D structures 122a, 312a and 212a, 412a, the contact trenches may be formed to expose at least an upper portion of the respective S/D contacts. Meanwhile, the contact trenches for the second top S/D contacts 224b, 324b may be formed with a depth such that the second bottom S/D contacts 114b, 414b remain covered by a portion of the ILD layer 30 and/or the dielectric contact capping layer 116b, 416b. The etching of the contact trenches for the second top S/D contacts 224b, 324b may accordingly be stopped prior to or on the dielectric contact capping layer 116b, 416b.

After recessing the contact metal to form the S/D contacts 224a-b, 324a-b with a desired height, a dielectric contact capping layer 50 has been formed over the S/D contacts 224a-b, 324a-b, wherein reference sign 50a indicates the portion of the dielectric contact capping layer 50 on the first common S/D contact 324a (hereinafter first contact cap 50a) and reference sign 50b indicates the portion of the dielectric contact capping layer 50 on the second common S/D contact 224a (hereinafter second contact cap 50b). Suitable materials for the dielectric contact capping layer 50 include for instance SiO₂, SiN, SiCO, or SiOCN. The dielectric contact capping material may be deposited in the contact trenches. Overburden dielectric contact capping material may be removed in a planarization process, comprising e.g. CMP. While in the illustrated example, different fill patterns are used for the ILD layer 30 and the dielectric contact capping layer 50, it is also possible to form the ILD layer 30 and the dielectric contact capping layer 50 of a same material. Forming the dielectric contact capping layer 50 and the ILD layer 30 of different materials having an etch contrast may however facilitate subsequent process steps for contacting the S/D contacts 224a-b, 324a-b from a BEOL interconnect structure, among others by allowing via openings to be etched self-aligned to the S/D contacts 224a-b, 324a-b.

Still with reference to Fig. 11a-d, a first trench 54a for a first cross-couple contact has been formed by etching the gate cap 48a and the first contact cap 50a. Additionally, a portion of the gate spacer 26 present between the first RMG structure 40a and the first common S/D contact 324a (more specifically between the first gate stack 40aa and the first common S/D contact 324a) has been etched. The gate spacer 26 is hence be opened such that the first trench 54a bridges (i.e. by extending through and across) the gate spacer 26. The first trench 54a extends from the second gate stack 40ab, over the dielectric plug 38a, to the first common S/D contact 324a. The first trench 54a accordingly exposes a top surface of the second gate stack 40ab and a top surface of the first common S/D contact 324a.

Further, a second trench 54b for a second cross-couple contact has been formed by etching the gate cap 48b, the second contact cap 50b and a portion of the gate spacer 26 present between the second RMG structure 40b and the second common S/D contact 224a (more specifically between the fourth gate stack 40bb and the second common S/D contact 224a). The second trench 54b extends from the third gate stack 40ba, over the dielectric plug 38b, to the second common S/D contact 224a. The second trench 54b accordingly exposes a top surface of the third gate stack 40ba and a top surface of the second common S/D contact 224a.

The first and second trenches 54a-b have been formed by forming a trench mask layer 52 over the device structure 10 and patterning first and second trench openings 53a-b therein using a standard lithography and etching process. While depicted as a single material layer, the trench mask layer 52 may be a standard lithographic layer stack, for instance a SOG/SOC stack with a resist layer on top. The openings 53a-b have subsequently been transferred into the gate caps 48a-b, the contact caps 50a-b and the gate spacer portions. The trench mask layer 52 may subsequently be removed.

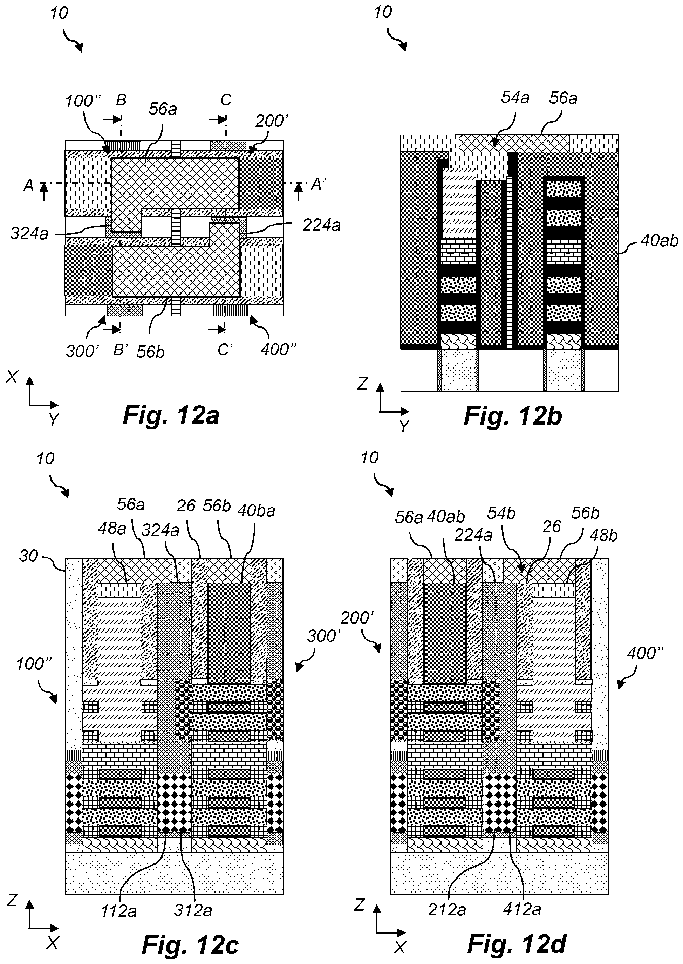

In Fig. 12, a first cross-couple contact 56a has been formed in the first trench 54a. The contact 56a interconnects the second gate stack 40ab and the first common S/D contact 324a. A second cross-couple contact 56b has been formed in the second trench 54b. The contact 56b interconnects the third gate stack 40ba and the second common S/D contact 224a. The first and second contacts 56a-b may be formed by filling the contact trenches 54a-b with one or more contact metals (e.g. a fill metal such as W, Co, Ni, Mo, Ru, or combinations thereof, and optionally a preceding deposition of a barrier metal layer and/or seed layer). After filling the trenches 54a-b, overburden metal may be removed from the device structure 10 using a planarization process comprising e.g. CMP and/or metal etch back.

Thereby, a pair of stacked transistor structures 200', 300' (e.g. a pair of CFETs) with respective gates cross-coupled to the first bottom S/D structure 112a, 412a of the respective non-stacked transistor structure 100", 200" (e.g. a pair of pass gates) may be formed.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device, comprising:
forming, over a substrate, a first bottom channel structure and a first top channel structure stacked on top of the first bottom channel structure, and a second bottom channel structure and a second top channel structure stacked on top of the second bottom channel structure, and a sacrificial gate extending across the first and second bottom and top channel structures;
forming an opening in the sacrificial gate, over the first top channel structure and forming a cut through the first top channel structure by etching the first top channel structure from the opening in the sacrificial gate, wherein the etching extends completely through the first top channel structure and is stopped over the first bottom channel structure;
forming a dielectric plug in the cut and the opening;
removing the sacrificial gate and subsequently forming a replacement metal gate (RMG) structure comprising a first gate stack on the first bottom channel structure and a second gate stack on the second bottom and top channel structures, and forming a dielectric gate capping layer over the RMG structure and the dielectric plug;
forming a first pair of source/drain (S/D) structures on the first bottom channel structure, a second pair of S/D structures on the second bottom channel structure, and a third pair of S/D structures on the second top channel structure;
forming S/D contacts on the S/D structures;
forming a dielectric contact capping layer over the S/D contacts;
forming a trench for a cross-couple contact by etching the dielectric gate capping layer and the dielectric contact capping layer, the trench extending from the second gate stack, over the dielectric plug, to a first S/D contact on a first S/D structure of the first pair of S/D structures; and
forming the cross-couple contact in the trench, the contact interconnecting the second gate stack and the first S/D contact.

2. A method according to claim 1, wherein the trench exposes a top surface of the second gate stack and a top surface of the first S/D contact.

3. A method according to claim 2, wherein the respective top surface of the first source/drain contact and the second gate stack is located at a level above the top surface of the dielectric plug.

4. A method according to any one of the preceding claims, wherein forming the trench further comprises etching a portion of a gate spacer present between the replacement metal gate structure and the first S/D contact.

5. A method according to any one of the preceding claims, wherein the first and the second gate stacks are separated by a vertically oriented dielectric wall.

6. A method according to claim 5, wherein the dielectric wall is formed between the first bottom and top channel structures and the second bottom and top channel structures prior to forming the sacrificial gate structure, and wherein the method comprises forming a cut in the RMG structure, landing on a top of the dielectric wall and the dielectric plug, to disconnect the first gate stack from the second gate stack.

7. A method according to any one of the preceding claims, wherein a dielectric separation layer is located between the first bottom and top channel structures, and between the second bottom and top channel structures, and wherein the etching for forming the cut through the first top channel structure is stopped over or on the dielectric separation layer.

8. A method according to any one of the preceding claims, wherein the opening is formed to selectively expose a top surface portion of the first top channel structure, wherein portions of the sacrificial gate remain along sidewalls of the first bottom and top channel structures after forming the opening.

9. A method according to any one of the preceding claims, further comprising applying, via the cut, an isotropic etching process for removing portions of the first top channel structure remaining along the cut.

10. A method according to claim 9, wherein a gate spacer is formed on sidewalls of the sacrificial gate, wherein the isotropic etching process removes end portions of the first top channel structure remaining below the gate spacer after forming the cut.

11. A method according to any one of claims 9-10, wherein the third pair of source/drain structures on the second top channel structure are formed in an epitaxy process subsequent to applying the isotropic etching process.

12. A method according to any one of the preceding claims, wherein the first bottom and top channel structures are formed along a first fin structure and the second bottom and top channel structures are formed along a second fin structure parallel to the first fin structure, wherein the sacrificial gate forms a first sacrificial gate extending transverse to the first and second fin structures, across the first and second bottom and top channel structures, and wherein the RMG structure forms a first RMG structure, and the method further comprising:
forming, along the first fin structure, a third bottom channel structure and a third top channel structure stacked on top of the third bottom channel structure, and a second sacrificial gate parallel to the first sacrificial gate and extending across the third bottom and top channel structures;
removing the second sacrificial gate and subsequently forming a second RMG structure comprising a third gate stack on the third bottom and top channel structures; and
forming a fourth pair of S/D structures on the third bottom channel structure and a fifth pair of S/D structures on the third top channel structure, wherein a first S/D structure of the fourth pair of S/D structures merges with the first S/D structure of the first pair of S/D structures;
wherein forming the S/D contacts comprises forming said first S/D contact on the merged first S/D structures and a first S/D structure of the fifth pair of S/D structures.

13. A method according to claim 12, when dependent on any one of claims 9-11, wherein the third and fifth pairs of source/drain structures are formed in an epitaxy process subsequent to applying the isotropic etching process.

14. A method according to any one of claims 12-13, further comprising:
forming, along the second fin structure, a fourth bottom channel structure and a fourth top channel structure stacked on top of the fourth bottom channel structure, wherein the second sacrificial gate is formed to further extend across the fourth bottom and top channel structures;
forming an opening in the second sacrificial gate, over the fourth top channel structure and forming a cut through the fourth top channel structure by etching the fourth top channel structure from the opening in the second sacrificial gate, wherein the etching extends completely through the fourth top channel structure and is stopped over the fourth bottom channel structure;
forming a second dielectric plug in the cut through the fourth top channel structure and the opening in the second sacrificial gate;
removing the second sacrificial gate and subsequently forming the second RMG structure comprising a third gate stack on the third bottom and top channel structures, and a fourth gate stack on the fourth bottom channel structure, and forming a second dielectric gate capping layer over the second RMG structure and the second dielectric plug;
forming a sixth pair of S/D structures on the fourth bottom channel structure,
wherein a first S/D structure of the sixth pair of S/D structures merges with a first S/D structure of the second pair of S/D structures formed on the second bottom channel structure, and
wherein forming the S/D contacts comprises forming a second S/D contact on the merged first S/D structures and a first S/D structure of the second pair of S/D structures;
forming a second trench for a second cross-couple contact by etching the second dielectric gate capping layer and the second dielectric contact capping layer, the second trench extending from the third gate stack, over the second dielectric plug, to the second S/D contact; and
forming the second cross-couple contact in the second trench, the second contact interconnecting the third gate stack and the second S/D contact.

15. A method according to any one of the preceding claims, wherein the second gate stack comprises a lower gate sub-stack surrounding the second bottom channel structure and an upper gate sub-stack surrounding the second top channel structure, and
wherein the first gate stack and the lower gate sub-stack is an N-type gate and the upper gate sub-stack is a P-type gate stack, or vice versa.
